(19) Europäisches Patentamt
European Patent Office
Office européen des brevets

(11) Publication number: 0 374 874 A2

# (12) EUROPEAN PATENT APPLICATION

(21) Application number: 89123539.2

(22) Date of filing: 20.12.89

(51) Int. Cl.5: B32B 27/04, B32B 15/08, B32B 31/20, H05K 1/03, H05K 3/46

(30) Priority: 23.12.88 US 288999
27.01.89 US 302206
14.02.89 US 309857

(43) Date of publication of application: 27.06.90 Bulletin 90/26

(84) Designated Contracting States: AT BE CH DE ES FR GB GR IT LI LU NL SE

(71) Applicant: THE B.F. GOODRICH COMPANY
3925 Embassy Parkway
Akron Ohio 44313-1799(US)

(72) Inventor: Benedikt, George M.
1010 Ledge Road
Macedonia Ohio 44056(US)
Inventor: Aleksa, David M.
10001 Munich Drive
Parma Ohio 44130(US)
Inventor: Tenney, Linwood P.
1731 Wellington Road
Birmingham Alabama 35209(US)

(74) Representative: von Kreisler, Alek et al
Patentanwälte von Kreisler Selting Werner
Deichmannhaus am Hauptbahnhof
D-5000 Köln 1(DE)

## (54) Polynorbornene prepreg laminated to conductive surface.

(57) Laminates are provided of at least one polynorbornene prepreg comprising a substrate coated with a polynorbornene secured to a conductive surface, such as copper having an etched matte texture thereon. Adhesion between the polynorbornene prepreg and the conductive surface is improved by coating the conducting surface with as silane coupling agent and/or by providing polyolefin film therebetween. To improve or reduce the dielectric constant, polyolefin powder can be placed in the dipping bath in the preparation of polynorbornene prepregs. Epoxy prepreg can also be incorporated into the laminates. Multi-layer laminates can be provided of alternating or non-alternating epoxy prepregs and polynorbornene prepregs. The prepregs are made by a process which includes an adhesion promotion step wherein the prepreg, preferably polynorbornene prepreg, prior to lamination, is pretreated with a silane adhesion promotion agent. One or more copper foils can also be employed between exterior surfaces of the prepregs, at the interface between the prepregs, as well as on the exterior of the laminates. The copper films can be etched to form patterns such as those suitable for printed circuit wiring boards.

EP 0 374 874 A2

# polynorbornene prepreg LAMINATED TO CONDUCTIVE SURFACE

## BACKGROUND OF THE INVENTION

This invention relates to laminates and more specifically to printed circuit wiring boards composed of a polynorbornene prepreg laminated to a conductive surface with a layer of polyolefin film derived from $C_2$-$C_4$ monomers sandwiched therebetween to improve adhesion. To obtain an improved or a lower dielectric constant, polyolefin powder can be provided in the dipping bath together with a polynorbornene resin. The printed circuit wiring boards can also have an epoxy prepreg laminated to the polynorbornene prepreg or to a conductive surface. A silane coupling agent can be used to improve bonding between a conductive surface and a polynorbornene prepreg or between an epoxy prepreg and a polynorbornene prepreg.

The purpose of the present invention is to produce printed circuit wire boards which have a low dielectric constant and high bonding strength.

In conventional processes, so called "prepregs" are made by dipping a pretreated fibrous substrate, such as fiberglass, in a solution or dispersion of a polymer resin having good strength and electrical insulating properties and drying the fibrous substrate to remove the solvent or dispersant and to provide a resin-impregnated substrate.

Cellulosic and fiberglass woven and nonwoven materials have long been used to reinforce polymer substrates. It is known that silane coupling agents can be applied directly to glass filaments to improve the flexural strength of glass cloth laminates of a variety of resins, often by as much as 300 percent, for compression molded test samples. Silane coupling agents at the interface allow many particulate minerals to become reinforcing fillers in composites to increase strength, hardness, modulus, heat distortion and impact strength.

After a fiberglass mat is dipped in a bath and the solvent or dispersant is dried to form a prepreg, two or more of these prepregs are then pressed together to form an insulating layer for a printed circuit wiring board. To provide the conducting surface for the laminate, one or more copper films are generally pressed against the exposed surfaces of these prepregs.

The laminates are generally compared in the marketplace for dielectric constant, dissipation factor, chemical resistance, peel strength, solder bath resistance at 260°C to 288°C, warping and punchability.

Methods of applying metals to prepregs include vapor deposition, electroplating, sputtering, ion plating, spraying and layering. The metals commonly used include copper, nickel, tin, silver solder, gold, aluminum, platinum, titanium, zinc and chrome, with copper being used most often in printed wire boards.

A problem associated with forming thin metallic coatings on insulating layers or substrates has been the inability to form a complete bond having excellent bond strength between the metallic layer and the substrate and subsequently good solder resistance.

Silane compounds have found wide acceptability for improving adhesion between different substrates.

Silane coupling agents modify the interface between metal or mineral surfaces and organic resins to improve adhesion between the surface and the resin. The physical properties and water resistance of the reinforced resins are thereby improved. It is believed that silane coupling agents form bonds with metal surfaces through the silane functional group. The hydrolyzed silanes will condense to oligomeric siloxanols and eventually to rigid crosslinked structures. Contact with a polymer matrix should take place while the siloxanols still have some solubility. Bonding to a polymer matrix may take different forms or a combination of forms. Bonding may be covalent where the oligomeric siloxanol is compatible with the liquid matrix resin. The solutions might also form an interpenetrating polymer network as the siloxanols and the resin separately cure with only limited copolymerization.

It is well known that not all silanes or mixtures of silanes will bond all metals to all substrates. McGee, 4,315,970, states that:

> "[i]t is generally accepted that specific silanes can be used for adhesion of specific materials to specific substrates. That is, the silane must be matched to the application and it cannot be assumed that all silanes will work in all applications."

Therefore, the suitability of a silane bonding agent in improving adhesion of a metal to a substrate is unpredictable and it must be determined by experimentation.

While suitable coupling agents are commercially available for bonding of many common plastics with a variety of metals, it is believed that the application of silane coupling agents for bonding of polynorbornenes to metals is not known in the prior art nor the use of silane coupling agents to bond epoxy resins to polynorbornene resins.

## SUMMARY OF THE INVENTION

Laminates used as printed wiring boards of the present invention comprise a polynorbornene prepreg and a conductive surface laminated together To improve adhesion between a conductive surface and a polynorbornene prepreg, a polyolefin film can be interposed between the conductive surface and the polynorbornene prepreg. Polyolefin powder can be added to the dipping bath into which a non-cellulosic cloth is dipped and then dried to remove the solvent in order to further reduce dielectric constant of the polynorbornene prepregs. It has been found that when a conductive surface, which can be for example a copper foil of the type generally used for printed wiring boards, is pretreated with certain silane compounds and then laminated to a prepreg at temperatures above the glass transition (Tg) temperature of the polymer in the prepreg, a printed wiring board having improved adhesion, solvent resistance and resistance to blistering is obtained. To improve adhesion, a polyolefin film derived from $C_{2-4}$ monomers can be interposed between the conductive surface and the polynorbornene prepreg. To improve or reduce dielectric constant of the polynorbornene prepreg, polyolefin powder is used in the dipping bath which then contains not only a polynorbornene resin but also the polyolefin powder.

Printed wiring boards of this invention also comprise a laminate formed of at least one polynorbornene prepreg and at least one epoxy prepreg. The epoxy prepreg and the polynorbornene prepreg are laminated to each other after pretreatment of the surface of the polynorbornene prepreg with a silane coupling agent. Several polynorbornene/epoxy prepregs may be employed. An etched film of a conductive material, such as copper, is preferably employed between the epoxy and polynorbornene prepregs. Te copper film is also treated with a silane coupling agent. Thus, the silane coupling agent is employed at each epoxy/norbornene interface and at each polynorbornene/copper interface.

## DETAILED DESCRIPTION OF THE INVENTION

The present invention provides laminates, such as printing wire boards, having superior bonding strength and dielectric properties by laminating a substrate layer, such as one or more epoxy and/or polynorbornene prepregs of fiberglass-reinforced polymer to a conductive foil, for example a copper foil, coated with a silane coupling agent. The printing wire boards of this invention with a polyolefin film interposed between a conductive layer and a polynorbornene prepreg show low solvent swellings at room temperature in methylene chloride of less than 40%, preferably less than 25% and even more preferably less than 15% in a 60 mil thick sample. They have a coefficient of thermal expansion normal to the plant of the board surface preferably below 80 ppm/°C. The printing wiring boards of this invention are preferably resistance to the thermal stress in a solder bath at 260°C for at least 20 seconds without copper delamination or blistering. The polyolefin film, such as polyethylene, also provides for oxidation resistance when the conductive metal film is etched away. The laminates of this invention, when used as printed wiring boards, have a low dielectric constant. The polynorbornene layers exhibit particularly low dielectric constants. Thus, the polynorbornene layers contribute to the low overall dielectric constants exhibited by the laminates of this invention. The dielectric constant of the epoxy layers is preferably not greater than 4.8 and the dissipation factor is preferably not greater than 0.02. The polynorbornene layers preferably have a dielectric constant of not greater than about 2.8 - 3.1, and a dissipation factor of 0.002 or less.

As used herein, a polynorbornene (PN) prepreg is composed of a substrate, such as a fiberglass mat, and a coating of a PN resin on its surface. The PN resin can be prepared from homopolymers or copolymers containing up to 20%, preferably up to 10%, of a suitable comonomer rather than a monomer containing a norbornene group. The prepregs can be made by dipping a substrate in a dipping bath. The dipping bath can contain other suitable additives which additives become part of the coating. Polyolefin (PE) powder can be added to the polynorbornene bath to reduce further the dielectric constant of a polynorbornene prepreg. Epoxy prepregs are made by dipping a substrate, such as a fiberglass mat, into an epoxy bath.

In the present invention, the prepregs are made by dipping a substrate in a dipping bath or solution. This dipping solution comprises solubilized polynorbornene polymers together with or devoid of polyolefin. The polynorbornene polymers are obtained from the metathesis ring-opening polymerization of cycloolefin monomers having a norbornene functional group.

These cycloolefin monomers are characterized by the presence of at least one norbornene moiety in its structure identified below:

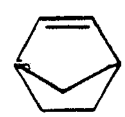

Suitable cycloolefin monomers include substituted and unsubstituted norbornenes, dicyclopentadienes, dihydrodicyclopentadienes, trimer of cyclopentadiene, tetracyclododecenes, hexacycloheptadecenes, ethylidenyl norbornenes and vinylnorbornenes. Substituents on the cycloolefin monomers include hydrogen, alkyl, alkenyl, and aryl groups of 1 to 20 carbon atoms, and saturated and unsaturated cyclic groups of 3 to 12 carbon atoms which can be formed with one or more, preferably two, ring carbon atoms. In a preferred embodiment, the substituents are selected from hydrogen and alkyl groups of 1 to 2 carbon atoms. Generally speaking, the substituents on the cycloolefin monomers can be any which do not poison or deactivate the polymerization catalyst. Examples of the preferred monomers referred to herein include, one or more of the following monomers to provide either homopolymers or copolymers of two or more monomers upon polymerization: norbornene, 5-vinyl-norbornene, methylnorbornene, tetracyclododecene, methyltetracyclododecene, dicyclopentadiene, 5-ethylidenyl-2-norbornene, hexacycloheptadecene, and tricyclopentadiene.

Other monomers can form part of the polynorbornenes such as non-conjugated acyclic olefins, monocyclic olefins and diolefins. The non-conjugated acyclic olefins act as chain terminators. Terminal olefins are most preferred, e.g., alpha-olefins. Thus, monomers like hexene-1 are preferred while 1-butene, 2-pentene, 4-methyl-2-pentene, and 5-ethyl-3-octene are also suitable. They are typically used at a molar ratio of 0.001:1 to 0.5:1 acyclic olefin to cycloolefin monomer.

The polynorbornenes used in forming the printed wire boards of the present invention are obtained by solution polymerization. For solution polymerization, the catalyst preferably comprises molybdenum or tungsten salts and the cocatalyst preferably comprises dialkylaluminum halides, alkylaluminum dihalides, alkylalkoxy halide or a mixture of trialkylaluminum with an iodine source.

Examples of useful molybdenum and tungsten salts include the halides such as chlorides, bromides, iodides, and fluorides. Specific examples of such halides include molybdenum pentachloride, molybdenum hexachloride, molybdenum pentabromide, molybdenum hexabromide, molybdenum pentaiodide, molybdenum hexafluoride, tungsten hexachloride, tungsten hexafluoride and the like. Other representative salts include those of acetylacetonates, sulfates, phosphates, nitrates, and the like. Mixtures of salts can also be used. For polymerization results, the more preferred salts are the molybdenum halides, especially molybdenum pentahalides such as $MoCl_5$.

Specific examples of cocatalysts for ring-opening solution polymerization include organoaluminum halides or more specifically alkylaluminum halides such as ethylaluminum sesquichloride, diethylaluminum chloride, diethylaluminum iodide, ethylaluminum diiodide, propylaluminum diiodide, ethylpropylaluminum iodide, and a mixture of triethylaluminum and elemental iodine.

For solution polymerization, the molybdenum or tungsten salt is generally employed at a level from about 0.01 to about 50 millimoles per mole of total monomer, preferably from about 0.5 to about 10 millimoles, and the organoaluminum compounds described above are generally used in a molar ratio of organoaluminum compound to molybdenum and/or tungsten salt(s) from about 10/1 to about 1/3, preferably from about 5/1 to about 3/1. Both catalyst and cocatalyst for solution polymerization are normally added at the time of polymerization.

Suitable solvents used for the solution polymerization and in forming the dipping solution include aliphatic and cycloaliphatic hydrocarbon solvents containing 4 to 10 carbon atoms such as cyclohexane, cyclooctane and the like; aromatic hydrocarbon solvents containing 6 to 14 carbon atoms which are liquid or easily liquified such as benzene, toluene, xylene and the like; and substituted hydrocarbons wherein the substituents are inert such as dichloromethane, chloroform, chlorobenzene, dichlorobenzene and the like.

Optionally, present in the dipping solution are curing agents which initiate radical crosslinking such as the peroxides, di-t-butyl peroxide, or 2,5-diemethyl-2,5-di(t-butylperoxy)-hexyne-3. Antioxidants such as hindered phenol antioxidants (Ethyl 330) and polyunsaturated monomeric or oligomeric crosslinkers such as trimethylol propane triacrylate are also optional.

The dipping solution is impregnated into a noncellulosic cloth, such as fiberglass to form a coated substrate layer, often referred to as a prepreg. The cloth may be woven or nonwoven. Many glass cloth materials having a variety of surface characteristics are available commercially. In the present invention, E-type fiberglass cloth, style 2116, having a surface finish type 642 or 627, which refers to a silane treatment, made by Burlington Industries, is preferred. The noncellulosic cloth is impregnated by immersing it in the dipping solution of a resin, such as polynorbornene resin, in an organic solvent. This can be accomplished at ambient temperatures or at the temperatures above or below ambient temperatures.

The glass cloth may be pretreated with a silane solution. A preferred class of pretreating agents is the styryl diamino silanes.

Polyolefin can be added to the dipping solution. Particularly suitable polyethylene powders include MICROTHENE FN 524 and MICROTHENE FN 510, available from USI. It is also possible to employ polyolefin powder prepared from ground or otherwise finely divided polyolefin pellets. Powder particle sizes of 100 micron (0.1 mm) size or less are especially suitable. The polyethylene component is fully conventional, readily available and well-known to those of ordinary skill in the art. Other polyolefins are also fully conventional, readily available, and well known.

The polynorbornene-polyolefin blend is preferably employed in a weight ratio of from about 40:60 to about 90:10 of polynorbornene to polyolefin, more preferably from 45:55 to 65:35 polynorbornene to polyolefin. Blends of 1:1 polynorbornene and polyolefin are particularly useful.

Epoxy prepregs suitable for use in this invention are fully conventional and are readily commercially available. A particularly suitable epoxy prepreg comprises a commercial brominated epoxy/dicyandiamide B-stage prepreg. Some considerations for selecting resins for use in printed circuit boards are disclosed in "Some approaches to low dielectric constant matrix resin for printed circuit boards", Butler et al., National SAMPLE Technical Conference, Oct. 4-6, 1983, which disclosure is hereby incorporated by reference herein.

The dipping solutions have solids content of preferably about 10% to about 40%. Dipping solutions having concentrations both above and below this range can be used in forming the laminates of the invention.

The prepreg so produced is typically dried at temperatures between ambient temperature and about 150° C. At final stages of drying, the temperature is preferably maintained above the glass transition temperature (Tg) of the polymer to permit the solvent to diffuse out. If curing agents are present, the temperature is kept sufficiently low to prevent activation of radical cross-linking.

Under typical conditions, for example, when a high molecular weight $C_2$-$C_4$ polymer is employed, it is not dissolved by the solvent of the dipping solution but is suspended therein. For example, under most cases, the MICROTHENE powders employed form a suspension. Once impregnated into the prepreg and dried, the prepreg could show some opacity due to phase separation of the polymer components. Typical curing conditions involve placing the dried prepreg in a 180° C to 220° C over a 25 minute period. The prepreg is then maintained at 220° C for another 25 minutes. Under these conditions, the $C_2$-$C_4$ polyolefin phase is melted and instead of the two-phase mixture, which was present before curing, one phase develops. Subsequently, during final curing, a cross-linked product develops.

Commercially, the drying is conducted in a continuous drying system, for example, a continuous drying tower as part of a treater having a temperature gradient from room temperature up to 220° C. Treaters are well known to those of ordinary skill in the art, are fully conventional (they are employed in the production of conventional epoxy prepregs), and can be readily employed in the process of this invention, perhaps with a few routine optimization experiments.

The laminates produced by the present invention incorporate a conductive surface, preferably a copper film with a copper surface layer, such as copper foil. The copper surface layer is pretreated with a silane solution which increases the bond strength between the substrate and the copper surface layer. Preferably, copper foil of the type manufactured for printed wiring boards with a matte side for lamination to a prepreg is pretreated with such a solution of a silane coupling agent before being laminated to the prepreg. Such copper foils are typically about 35 microns thick and have dendritic bronze matte surface.

It is also feasible to employ a composite conductive sheet in which one face of the sheet is copper and the other is an appropriate metal such as tin, silver, gold, solder, aluminum, platinum, titanium, zinc, chrome, or an alloy of one or more of these metals with each other or copper. Additionally, the conductive foil may be composed of entirely only one of the above metals.

Particularly suitable foils for use between the epoxy and polynorbornene layer of this invention are copper foils which have been treated on each surface to provide a dendritic bronze matte surface. A particularly preferred foil is TC/TC double treated copper foil. Of course, it will be appreciated by those of ordinary skill in the art that other electrically conductive metals can be employed sa the foil layer.

According to the present invention several silanes were found to be p referred for bonding polynorbornene prepregs to the conductive surface and the polynorbornene prepregs to epoxy prepregs. The silane coupling agent is preferably in solution at concentrations ranging from about 1% to 10% by weight. Suitable silanes include: 3-methylacryloyloxypropyltrimethoxysilane, 3-(N-styrylmethyl-2-aminoethylamino)-propyltrimethoxysilane hydrochloride, 3-(N-allyl-2-aminoethylamino)-propyltrimethoxy-silane hydrochloride, N-(styrylmethyl)-3-aminopropyltrimethoxysilane hydrochloride, N-2-aminoethyl-3-aminopropyltrimethoxysilane, and 3-(N-benzyl-2-aminoethylamino)-propyltrimethoxy silane hydrochloride.

The laminates of this invention also include a polyolefin layer, such as polyethylene film, disposed between the conductive surface and the

polynorbornene prepreg. Advantageously, the polyethylene is in the form of a film or very thin sheet. The use of the polyolefin film improves adhesion between the polynorbornene prepreg and the conductive surface. Since a silane-coated conductive foil is used, the adhesion improvement takes place between the resin on the prepreg and the silane coating.

Suitable polyolefin film thicknesses include films of up to about 10 mils in thickness. If thicker films are employed, the thermal coefficient of expansion of the resultant laminate increases. Preferred thicknesses are those of less than 5 mils, preferably 1.5 mils or less and most preferably less than 1.5 mils.

Virtually any linear or branched polyolefin film derived from $C_2$-$C_4$ monomers is suitable to be employed in the invention. The molecular weight of the polyolefin is not critical. The film need not be oriented. Thus, any polyolefin film meeting the above thickness parameters may be employed. By providing pol.olefin in thin film form, good plastic flow is achieved when the laminate is subjected to heat and pressure. It is believed that as the polyolefin film undergoes this plastic flow, the polyolefin crosslinks with the norbornene of the prepreg, providing improved adhesion.

Examples of suitable $C_2$-$C_4$ olefins include ethylene, propylene, and butylene. Thus, suitable polyolefins include polyethylene, polypropylene and polybutylene. Polyethylene has been found to be particularly suitable. However, when used herein, it will be readily understood that polyethylene can be interchanged with the other polymers derived from $C_2$-$C_4$ olefins. Moreover, mixtures of such polyners and polymers derived from mixtures of such monomers can be employed.

The polyolefin film can also be employed between prepregs. Thus, the various sequences of prepreg, polyolefin and copper can be used, although, generally, the copper is on the exterior surface.

Various stacking sequences will be readily apparent to those of ordinary skill in the art. Following assembly of the prepregs in a desirable sequence, including the conductive surface, they are laminated to each other essentially concurrently. It will be appreciated by those of ordinary skill in the art that a sequence can be repeated as often as desired. It will also be appreciated that each sequence can contain as many prepregs as desired.

The laminates are produced by assembling a substrate of at least one polynorbornene or epoxy prepreg and copper foil pretreated as discussed above, and laminating these together. The copper is then imaged and preferably etched, as is well known. Subsequently, a second prepreg layer can be laminated between the initial prepreg and an additional copper foil. Preferably, the initial prepreg is laminated to two sheets of copper foil, one on each side, each of which is subsequently imaged and preferably etched. And preferably, two prepreg layers of dissimilar polymer along with one copper foil for each prepreg layer are laminated to each face of the initial laminate. Thus, using the sequence discussed above, if the initial prepregs are polynorbornene, copper/epoxy/copper/polynorbornene/copper/epoxy/copper laminate results. These layers can be built-up in alternating epoxy/polynorbornene sequence until the desired number of layers is reached. Any number of epoxy prepregs and polynorbornene prepregs can be employed in the prepreg layers. As used herein, the phrase "alternating layers" is not intended to limit this invention to strictly alternating epoxy/polynorbornene prepregs. Thus, it will be understood that several layers of epoxy prepregs can be employed with only one or two layers of polynorbornenes. Similarly, the polynorbornene and epoxy prepreg layers can comprise several prepregs and there is no practical limit on the number which can be employed in each layer. As used herein, the term "layer" refers to an assembly of prepregs which have been laminated together and cured, either independently of each other, or concurrently with other layers, optionally together with a layer of conductive film which, for example, has been etched or patterned and oxidized.

Preferably, layers are arranged in a stacking sequence and laminated concurrently. For example, assuming a substrate having the sequence of copper/polynorbornene/copper has been prepared, a sequence of copper/epoxy/substrate/epoxy/copper would be prepared and laminated under heat and pressure. In the simplest case for the production of printed circuit wiring boards, an assembly of polynorbornene/epoxy/copper, or epoxy/polynorbornene/copper would be prepared.

Alternatively, epoxy and/or polynorbornene layers can be prepared, and one or both faces of each layer laminated to a conductive film and cured, the lamination and cure of the epoxy and norbornene layers taking place independently. Thus, for example, a copper/epoxy/copper unit can be laminated and cured independently, and a copper/polynorbornene/copper unit can be laminated and cured independently such that the foregoing units are not yet laminated to each other, i.e., they exist as separate entities. One or more of the copper layers of each entity can then be subjected to photo-resist imaging and etching to form a copper pattern. Subsequently, the polynorbornene can be subjected to silane pretreatment, followed by laminating and curing the etched polynorbornene

unit with the etched epoxy unit to produce a printed wiring board.

The laminates of this invention have two major surfaces and four edge surfaces. The major surfaces are generally parallel to the plane of the laminations.

Laminates of this invention can comprise multilayer printed circuit boards. Multi-layer printed circuit boards are similar to single layer printed circuit boards except that the initial unit can be repeated any number of times. Thus, multi-layer circuit boards containing circuits of various layers can be fabricated. Generally, multi=layer circuit boards are prepared by first preparing an initial unit. The copper is then subjected to conventional photoresist imaging techniques and etched. An etched pattern results, which is capable of functioning as a circuit. The outside of the remaining copper layer is preferably oxidized with a conventional oxidant. Thereafter, an additional unit is laminated to the etched copper side of the substrate such that the additional copper layers are on the outside. This process is continued until the desired number of layers of the multi-layer laminate is reached. Methods of fabricating multilayer printed circuit boards, including those steps in this invention which are conventional, are disclosed in Printed Circuits Handbook, Coombs Jr., McGraw-Hill, 1979, Chapter 22, which is hereby incorporated by reference herein.

The laminates, such as printed wire boards, are finished by laminating the pretreated copper layer to the prepreg. The polyolefin film can be sandwiched between the prepreg substrate and the copper foil such that the polyolefin film is bonded to each surface.

Lamination of the prepregs and the conductive surface is accomplished in a heated press using pressures above about 700 psi, preferably above 1000-1100 psi and at temperatures between ambient temperature and 250°C, but preferably between 170°C and 190°C. Preferably, the temperature is above the glass transition temperature of the polynorbornene and sufficiently high to activate any peroxide curing agents. At such temperatures, any peroxide curing agent present in the polymer releases an oxygen free radical which causes crosslinking. Crosslinking provides strength and chemical resistance to the boards. Generally, a stack of prepregs may be pressed between a pair of pretreated copper foils. The pretreated bronze side of the copper foil is placed in contact with the prepreg.

The laminates resulting from the process of this invention are used in the manufacture of printed circuit boards or more precisely, printed circuit wiring boards. A very basic way in which the laminates of the invention can be employed to make printed circuit boards can be found in CMOS Cookbook., Lancaster, Sams &Company, 1977, pages 32-34.

The following examples are provided to illustrate preferred embodiments of the present invention. They are not intended to limit the scope of this disclosure to the embodiments exemplified therein. All percentages are by weight unless specified otherwise.

## EXAMPLE 1

### Step 1

### Preparation of 65/35 (wt/wt) Methyltetracyclododecene (MTD) Vinyl-Norbornene (VNB) Copolymer

Preparation of the polynorbornene (PN) copolymer is illustrated herein.

An unsaturated polynorbornene polymer was obtained in the following manner. Into a septum-capped vessel containing 30 grams (g) of molecular sieves wewre added 81 g of dry toluene, 10.22 g of methyl tetracyclododecene, 5.73 g vinyl norbornene and 4.90 g hexene-1. The contents were mixed and this mixture was allowed to stand 30 minutes, then transferred to a second vessel by passing it through a 1 micron filter under nitrogen pressure. The vessel was slightly pressurized with nitrogen. To the mixture 0.23 cc of a 25% solution of ethylaluminumsesquichloride cocatalyst in dry toluene were introduced by syringe. To this mixture, 1.65 cc of a solution of 2 g of molybdenum pentachloride catalyst in 39 g of dry ethylacetate and 84 g of dry toluene, were also introduced by syringe. Within one minute, an exothermic reaction of the mixture resulted and the mixture became a viscous liquid. After 15 minutes, 60 cc of a 881/12 (wt/wt) mixture of 2-propanol and water was added to the vessel and the contents shaken to inactivate the catalyst. The top layer containing mostly solvents, residual monomers and low moleculars weight polymers was poured off. The semisolid bottom layer was redissolved in 100 cc of toluene, washed with water and dried by azeotropic distillation of part of the solvent.

Polymerization was found to result in 91% conversion of monomer, as calculated by measuring the weight percent solids of the resulting polymer solution. The glass transition temperature (Tg) was found to be 118°C in the second heat, as cal-

test are at least equivalent to the ASTM D 1867-82 and Military Specification MIL-P-13949F standard tests of 90 degree peel strength and 288° solder bath resistance for 10 seconds.

The coefficient of thermal expansion was measured and found to be 89PPM/°C.

EXAMPLE 2

The experiment of Example 1 was repeated except that no adhesion promotion (silane coupling agent) of the copper foil was performed. The laminate showed blisters and a peel strength of below 2 lbs/in.

EXAMPLE 3

The experiment of Example 1 was repeated except that no polyethylene film was employed in the lamination. The copper peel strength of the laminate was measured to be 8.2 lbs/in.

EXAMPLE 4

PN prepregs were prepared as in Example 1 and stored for 14 days at 50°C. A laminate of the sequence of copper foil/PE film/PN prepreg/PE film/PN prepreg/copper foil was prepared. The copper foil was pretreated with a styryl silane solution as indicated above. The lamination was done for 30 minutes in a press at a temperature ranging from 180°C to 220°C and for 45 minutes at a temperature of 220°C. The copper foil/PE film adhesion appeared even better than the non-PE adhesion interface. A 2"x3" portion was tested in solder bath at 288°C, exhibiting only a slight bubble at an edge portion. The laminate exhibited peel strength values of 13.0 lbs/inch.

EXAMPLE 5

A laminate in a manner similar to Example 4 was prepared, except that no copper pretreatment was employed. The laminate exhibited bad adhesion and bubbles formed in the solder bath test.

EXAMPLE 6

A laminate was prepared in a manner similar to Example 4 having the sequence of copper/PE/PN prepreg/PE/PN prepreg/PE/PN prepreg/PE/PN prepreg/PE/copper. The copper was pretreated as above. The laminate, having a major surface dimension of 4"x4", passed a molten solder test at 500° and 550°F.

EXAMPLE 7

Two PN prepregs prepared were laminated and cured between pretreated copper foils at from 180°C to 220°C and 1,000 pounds of pressure per square inch for 30 minutes to provide a laminate. The increase in temperature was gradual at about 2 degrees per minute.

The laminate with polyolefin powder, as described in Step 2-B, exhibited a dielectric constant at 1 MHz of about 2.8 using E-type glass as measure on a Gen Rad 1687-B Megahertz LC Digibridge electric bridge. Without the polyolefin powder, the dielectric constant was 3.1, as noted in Example 8, below.

EXAMPLE 8

Example 1 was repeated except the polymer employed was 100% polynorbornene polymer described inStep 1. The laminate exhibited a dielectric constant of 3.1.

EXAMPLE 9

Example 1 was repeated except that the $C_2$-$C_4$ polyolefin employed was MICROTHENE FN 510 with a melt index 4.5 and density of 0.924. There was a 69.7% uptake of polymer blend by the glass cloth during the prepregging stage. The laminate exhibited a dielectric constant of 2.8, same as in Example 7.

EXAMPLE 10

Example 9 was repeated in the absence of polyolefin, i.e., the polymer employed was 100% polynorbornene copolymer described in Example 1, Step 1. The prepreg had a polymer uptake of 70% on glass and the resulting laminate exhibited a dielectric constant of 3.14.

test are at least equivalent to the ASTM D 1867-82 and Military Specification MIL-P-13949F standard tests of 90 degree peel strength and 288° solder bath resistance for 10 seconds.

The coefficient of thermal expansion was measured and found to be 89PPM/°C.

## EXAMPLE 2

The experiment of Example 1 was repeated except that no adhesion promotion (silane coupling agent) of the copper foil was performed. The laminate showed blisters and a peel strength of below 2 lbs/in.

## EXAMPLE 3

The experiment of Example 1 was repeated except that no polyethylene film was employed in the lamination. The copper peel strength of the laminate was measured to be 8.2 lbs/in.

## EXAMPLE 4

PN prepregs were prepared as in Example 1 and stored for 14 days at 50°C. A laminate of the sequence of copper foil/PE film/PN prepreg/PE film/PN prepreg/copper foil was prepared. The copper foil was pretreated with a styryl silane solution as indicated above. The lamination was done for 30 minutes in a press at a temperature ranging from 180°C to 220°C and for 45 minutes at a temperature of 220°C. The copper foil/PE film adhesion appeared even better than the non-PE adhesion interface. A 2"x3" portion was tested in solder bath at 288°C, exhibiting only a slight bubble at an edge portion. The laminate exhibited peel strength values of 13.0 lbs/inch.

## EXAMPLE 5

A laminate in a manner similar to Example 4 was prepared, except that no copper pretreatment was employed. The laminate exhibited bad adhesion and bubbles formed in the solder bath test.

## EXAMPLE 6

A laminate was prepared in a manner similar to Example 4 having the sequence of copper/PE/PN prepreg/PE/PN prepreg/PE/PN prepreg/PE/PN prepreg/PE/copper. The copper was pretreated as above. The laminate, having a major surface dimension of 4"x4", passed a molten solder test at 500° and 550°F.

## EXAMPLE 7

Two PN prepregs prepared were laminated and cured between pretreated copper foils at from 180°C to 220°C and 1,000 pounds of pressure per square inch for 30 minutes to provide a laminate. The increase in temperature was gradual at about 2 degrees per minute.

The laminate with polyolefin powder, as described in Step 2-B, exhibited a dielectric constant at 1 MHz of about 2.8 using E-type glass as measure on a Gen Rad 1687-B Megahertz LC Digibridge electric bridge. Without the polyolefin powder, the dielectric constant was 3.1, as noted in Example 8, below.

## EXAMPLE 8

Example 1 was repeated except the polymer employed was 100% polynorbornene polymer described inStep 1. The laminate exhibited a dielectric constant of 3.1.

## EXAMPLE 9

Example 1 was repeated except that the $C_2$-$C_4$ polyolefin employed was MICROTHENE FN 510 with a melt index 4.5 and density of 0.924. There was a 69.7% uptake of polymer blend by the glass cloth during the prepregging stage. The laminate exhibited a dielectric constant of 2.8, same as in Example 7.

## EXAMPLE 10

Example 9 was repeated in the absence of polyolefin, i.e., the polymer employed was 100% polynorbornene copolymer described in Example 1, Step 1. The prepreg had a polymer uptake of 70% on glass and the resulting laminate exhibited a dielectric constant of 3.14.

EXAMPLE 11

For preparing the laminates containing an epoxy prepreg, two PN prepregs were laminated in between electrodeposited copper foil, containing a proprietary bronze treatment on the matte side. Prior to lamination, the copper foil was treated for 1 minute by dipping in a 0.4% solution of 3-(N-styrylmethyl-2-aminoethyl)-aminopropyltrimethoxy silane hydrochloride in methanol as an adhesion promoter. The treated foil was subjected to a short bake for 5 minutes at 105°C. The lamination and cure were performed in a press at from 40 to 190°C for 25 minutes and, isothermally, at 190°C for 3 hrs, using a pressure of 700 psi. At this point, the copper peel strength was above 8 lbs/in and the sample passed, without blistering, the thermal stress test in a molten solder bath for 20 seconds at 288°C.

The copper on both sides of the laminate was imaged and etched using a 1 molar solution of ammonium persulfate. The etched board was at this point a cured substituted polynorbornene C-stage board. Based on Electron Spectroscopy for Chemical Analysis determination of silicon and nitrogen on the board surface, the copper adhesion promoter remained unetched on the board surface in the areas where the copper was removed. The copper pattern was treated with an oxidant to produce an oxide coating on the surface of the pattern.

In order to prepare a multi-layer board, on each side of the PN prepreg described above were laminated two epoxy prepregs, which were commercial brominated epoxy/dicyandiimide B-stage prepregs, and two copper foil on the outside, respectively. These copper foils were not pretreated with the adhesion promoter since in the manufacture of commercial epoxy boards, this treatment is not required. The lamination and cure were performed under the same temperature and pressure cycle as above. At this point, the sample passed the thermal stress test of 20 seconds at 288°C, showing good adhesion between the PN and the epoxy layers as well as between the epoxy layer and the copper foil.

The copper foil on the above laminate was imaged and etched using a 1 molar solution of ammonium persulfate, followed by oxidation.

The hybrid board having C-stage epoxy layers on the outside and the cured PN copolymer core was adhesion promoted by treatment for 1 minute with the same 0.4% solution in methanol of the silane compound used in Step 3, after which it was dried in air at 105°C for 5 minutes.

The treated board was further laminated with 2 layers on each side, of uncured PN prepregs and with adhesion promoted copper foils as already described.

The lamination and cure were performed as described above using 700 psi pressure and a temperature cycle from 40°C to 190°C in 25 minutes and then isothermally, at 190°C for 3 hours. At this point, the hybrid board was subjected to a thermal stress test for 20 seconds at 260°C and 20 seconds at 288°C. There was no blistering or delamination between the dissimilar epoxy and PN prepregs or between the copper foil and the outside PN prepreg.

The hybrid multi-layer printed circuit wiring board described in this example comprises, thus, 3 layers of cured PN prepreg alternating with two epoxy prepregs.

EXAMPLE 12

Example 1 was repeated except the adhesion promotion treatment with the silane coupling agent was not performed.

The board was subjected to a thermal stress test for 20 seconds at 260°C and showed delamination between the epoxy and the outside PN layers.

While this invention has been disclosed in this patent application by reference to the details of preferred embodiments of the invention, it is to be understood that this disclosure is intended in an illustrative rather than in a limiting sense, as it is contemplated that modifications will readily occur to those skilled in the art, within the spirit of the invention and the scope of the appended claims.

## Claims

1. Process for preparing a laminate comprising the step of securing a polynorbornene prepreg and a conductive surface.

2. Process of claim 1 wherein said securing step is carried out at pressure about 700 psi and at a temperature range of ambient to 250°C; the polynorbornene prepreg is prepared by dipping a non-cellulosic substrate in a dipping bath comprising a polynorbornene solution whereby at least a portion of the substrate is coated with the polynorbornene, and drying the coated substrate to obtain the polynorbornene prepreg.

3. Process of claim 2 wherein a $C_{2-4}$ polyolefin powder is placed in the dipping bath in the weight ratio of the polyolefin to the polyolefin powder of from 40:60 to 90:10 to reduce dielectric constant of the polynorbornene prepreg.

4. Process of claim 1 also including the step of

securing a $C_{2-4}$ polyolefin film between polynorbornene prepreg and the conductive surface to improve adhesion therebetween.

5. Process of claim 1 including the step of securing an epoxy prepreg to the polynorbornene prepreg and/or the conductive surface.

6. Process of claim 5 wherein said conductive surface has matte texture on at least one side thereof and wherein at least one side thereof has an amine silane coupling agent thereon.

7. Process of claim 6 wherein said coupling agent is selected from the group consisting essentially of 3-methylacryloyloxypropyltrimethoxysilane, 3-(N-styrylmethyl-2-aminoethylamino)-propyltrimethoxysilane hydrochloride, 3-(N-allyl-2-aminoethylamino)-propyltrimethoxysilane hydrochloride, N-(styrylmethyl)-3-aminopropyltrimethoxysilane hydrochloride, N-2-aminoethyl-3-aminopropyltrimethoxysilane, 3-(N-benzyl-2-aminoethylamino)-propyltrimethoxy silane hydrochloride, and mixtures thereof.

8. Process of claim 5 wherein solids content of the dipping bath is 10 to 40% by weight and the dipping bath contains an effective amount of a free radical curing agent.

9. Process of claim 5 further comprising the steps of exposing at least one of the conductive surfaces to photoresist imaging conditions and etching the surface to form a pattern thereon.

10. Process of claim 2 wherein the polynorbornene is selected from polymers of dicyclopentadiene, methylnorbornene, methyltetracyclododecene, vinyl norbornene, and mixtures thereof; wherein the securing step is performed at a temperature above glass transition temperature of the polynorbornene; and wherein the substrate comprises glass fibers.

11. Laminate comprising at least one polynorbornene prepreg and at least one conductive surface secured to said polynorbornene prepreg, said polynorbornene prepreg comprising a non-cellulosic substrate and a polynorbornene coating on its surface.

12. Laminate of claim 11 wherein said conductive surface has a silane coupling agent thereon.

13. Laminate of claim 12 including a $C_{2-4}$ polyolefin film disposed between said conductive surface and said polynorbornene prepreg.

14. Laminate of claim 12 including $C_{2-4}$ polyolefin particles in said coating, wherein weight ratio between polynorbornene and the polyolefin is in the range of 40:60 to 90:10, respectively.

15. Laminate of claim 12 including at least one epoxy prepreg.

16. Laminate of claim 15 wherein said epoxy prepreg is secured to said conductive surface.

17. Laminate of claim 12 wherein said epoxy prepreg is secured to said polynorbornene prepreg, and wherein said epoxy prepreg or said polynorbornene prepreg or both have a silane coupling agent thereon.

18. Laminate of claim 12 wherein said silane coupling agent is selected from the group consisting essentially of 3-methylacryloyloxypropyltrimethoxy-silane, 3-(N-styrylmethyl-2-aminoethylamino)-propyltrimethoxysilane hydrochloride, 3-(N-allyl-2-aminoethylamino)-propyltrimethoxysilane hydrochloride, N-(styrylmethyl)-3-aminopropyltrimethoxysilane hydrochloride, N-2-aminoethyl-3-aminopropyltrimethoxysilane, 3-(N-benzyl-2-aminoethylamino)-propyltrimethoxy silane hydrochloride, and mixtures thereof; wherein said polynorbornene is selected from polymers of dicyclopentadiene, methylnorbornene, methyltetracyclododecene, vinylnorbornene, and mixtures thereof; said substrate is non-cellulosic comprising glass fibers; and said conductive surface is etched copper having matte texture.

19. Laminate of claim 15 comprising at least one polynorbornene prepreg, at least one epoxy prepreg, and a conductive surface on the outer ends of said laminate.

20. Laminate of claim 19 used as a circuit wiring board wherein each epoxy prepreg has dielectric constant of 4.8 or less and dissipation factor of 0.02 or less, and each polynorbornene prepreg has dielectric constant of 3.1 or less and a dissipation factor of 0.002 or less.